# EUROPEAN PATENT APPLICATION

(11) **EP 4 618 135 A1**
(43) Date of publication of application: **17.09.2025**
(21) Application number: 23894469.8
(22) Date of filing: 13.11.2023
(51) Int. Cl.: H01L 21/205, H01L 21/3065, H05H 1/00, H05H 1/46

(54) **PLASMA PROCESSING DEVICE, POWER SUPPLY SYSTEM, AND METHOD FOR CONTROLLING SOURCE FREQUENCY**

(30) Priority: 22.11.2022 JP 2022186714
(71) Applicant: Tokyo Electron Limited, Tokyo 107-6325 (JP)
(72) Inventor: KOSAKA Yuto, Kurokawa-gun, Miyagi 981-3629 (JP)
(74) Representative: Hoffmann Eitle
(86) International application number: PCT/JP2023/040828
(87) International publication number: WO 2024/111460

(57) **Abstract**

In a plasma processing apparatus, a bias power supply provides an electrical bias having a waveform cycle to a substrate support. A radio-frequency power supply sets a time series of source frequencies of source radio-frequency power in a frequency adjustment cycle to include a maximum frequency in a first specific phase, a minimum frequency in a second specific phase, and an interpolated frequency in a phase other than at least two specific phases including the first and second specific phases. A phase difference between the frequency adjustment cycle and the waveform cycle is set to reduce a reflection degree of the source radio-frequency power. The radio-frequency power supply changes the maximum frequency in the first specific phase and the minimum frequency in the second specific phase in the time series of the source frequencies in the frequency adjustment cycle in a direction opposite to each other to reduce the reflection degree of the source radio-frequency power.

## Description

### FIELD

Exemplary embodiments of the disclosure relate to a plasma processing apparatus, a power supply system, and a method for controlling a frequency.

### BACKGROUND

A plasma processing apparatus performs plasma processing of substrates. The plasma processing apparatus provides source radio-frequency (RF) power to generate plasma from a gas in a chamber. The plasma processing apparatus uses bias RF power to draw ions from plasma generated in the chamber into a substrate. Patent Literature 1 below describes a plasma processing apparatus that modulates the power level and the frequency of bias RF power.

### CITATION LIST

### PATENT LITERATURE

Patent Literature 1: Japanese Unexamined Patent Application Publication No. 2009-246091

### BRIEF SUMMARY

### TECHNICAL PROBLEM

One or more aspects of the disclosure are directed to a technique for reducing the degree of reflection of source radio-frequency power.

### SOLUTION TO PROBLEM

A plasma processing apparatus according to one exemplary embodiment includes a chamber, a substrate support, a radio-frequency power supply, and a bias power supply. The substrate support is in the chamber. The radio-frequency power supply generates source radio-frequency power having a source frequency to generate plasma from a gas in the chamber. The bias power supply provides an electrical bias to the substrate support to draw ions from plasma in the chamber. The electrical bias has a waveform cycle. The radio-frequency power supply sets a time series of source frequencies of the source radio-frequency power in a frequency adjustment cycle having a same duration as the waveform cycle to include a maximum frequency in a first specific phase, a minimum frequency in a second specific phase, and an interpolated frequency in a phase other than least two specific phases including the first specific phase and the second specific phase. The radio-frequency power supply and the bias power supply set a phase difference between the frequency adjustment cycle and the waveform cycle to reduce a degree of reflection of the source radio-frequency power, and the frequency adjustment cycle has the source frequency changed based on a set of initial frequencies specifying initial source frequencies in the at least two specific phases. The radio-frequency power supply identifies, after setting the phase difference, the source frequency in the first specific phase and the source frequency in the second specific phase to reduce the degree of reflection of the source radio-frequency power while changing the maximum frequency in the first specific phase and the minimum frequency in the second specific phase in the time series of the source frequencies in the frequency adjustment cycle in a direction opposite to each other.

### ADVANTAGEOUS EFFECTS

The technique according to one exemplary embodiment reduces the degree of reflection of the source radio-frequency power.

### BRIEF DESCRIPTION OF DRAWINGS

FIG. 1 is a diagram of a plasma processing system, describing an example structure.
FIG. 2 is a diagram of a capacitively coupled plasma processing apparatus, describing an example structure.
FIG. 3 is a diagram of a power supply system in the plasma processing apparatus according to one exemplary embodiment, showing an example structure.
FIGs. 4A and 4B are graphs each showing an example waveform of an electrical bias.
FIGs. 5A to 5C are graphs each showing an example time series of source frequencies in the plasma processing apparatus according to the exemplary embodiment.
FIGs. 6A to 6B are graphs each showing an example time series of source frequencies in the plasma processing apparatus according to the exemplary embodiment.
FIG. 7 is a graph showing an example pulse of source radio-frequency power and an example pulse of an electrical bias.
FIGs. 8A to 8D are graphs each showing an example time series of source frequencies in the plasma processing apparatus according to the exemplary embodiment.
FIG. 9 is a flowchart of a method for controlling the source frequency according to the exemplary embodiment.

### DETAILED DESCRIPTION

Exemplary embodiments will now be described in detail with reference to the drawings. In the figures, like reference numerals denote like or corresponding components.

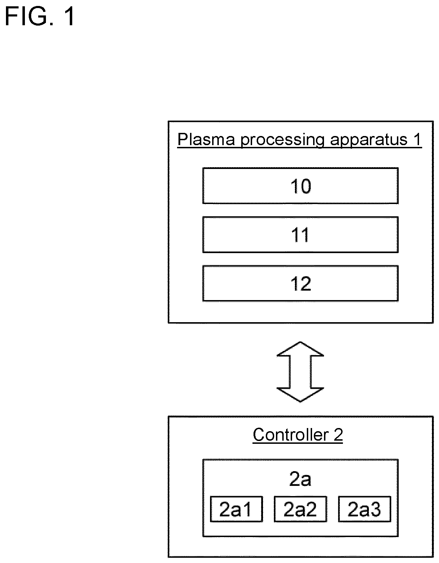

FIG. 1 is a diagram of a plasma processing system, describing an example structure. In one embodiment, the plasma processing system includes a plasma processing apparatus 1 and a controller 2. The plasma processing system is an example of a substrate processing system. The plasma processing apparatus 1 is an example of a substrate processing apparatus. The plasma processing apparatus 1 includes a plasma processing chamber 10, a substrate support 11, and a plasma generator 12. The plasma processing chamber 10 has a plasma processing space. The plasma processing chamber 10 has at least one gas inlet for supplying at least one process gas into the plasma processing space and at least one gas outlet for discharging the gas from the plasma processing space. The gas inlet is connected to a gas supply 20 (described later). The gas outlet is connected to an exhaust system 40 (described later). The substrate support 11 is located in the plasma processing space and has a substrate support surface for supporting a substrate.

The plasma generator 12 generates plasma from at least one process gas supplied into the plasma processing space. The plasma generated in the plasma processing space may be capacitively coupled plasma (CCP), inductively coupled plasma (ICP), electron cyclotron resonance (ECR) plasma, helicon wave plasma (HWP), or surface wave plasma (SWP).

The controller 2 processes computer-executable instructions that cause the plasma processing apparatus 1 to perform various steps described in one or more embodiments of the disclosure. The controller 2 may control the components of the plasma processing apparatus 1 to perform the various steps described herein. In one embodiment, some or all of the components of the controller 2 may be included in the plasma processing apparatus 1. The controller 2 may include a processor 2a1, a storage 2a2, and a communication interface 2a3. The controller 2 is implemented by, for example, a computer 2a. The processor 2a1 may perform various control operations by loading a program from the storage 2a2 and executing the loaded program. The program may be prestored in the storage 2a2 or may be obtained through a medium as appropriate. The obtained program is stored into the storage 2a2 to be loaded from the storage 2a2 and executed by the processor 2a1. The medium may be one of various storage media readable by the computer 2a, or a communication line connected to the communication interface 2a3. The processor 2a1 may be a programmable logic device such as a central processing unit (CPU) or a field-programmable gate array (FPGA). The storage 2a2 may include a random-access memory (RAM), a read-only memory (ROM), a hard disk drive (HDD), a solid-state drive (SSD), or a combination of these. The communication interface 2a3 may communicate with the plasma processing apparatus 1 through a communication line such as a local area network (LAN).

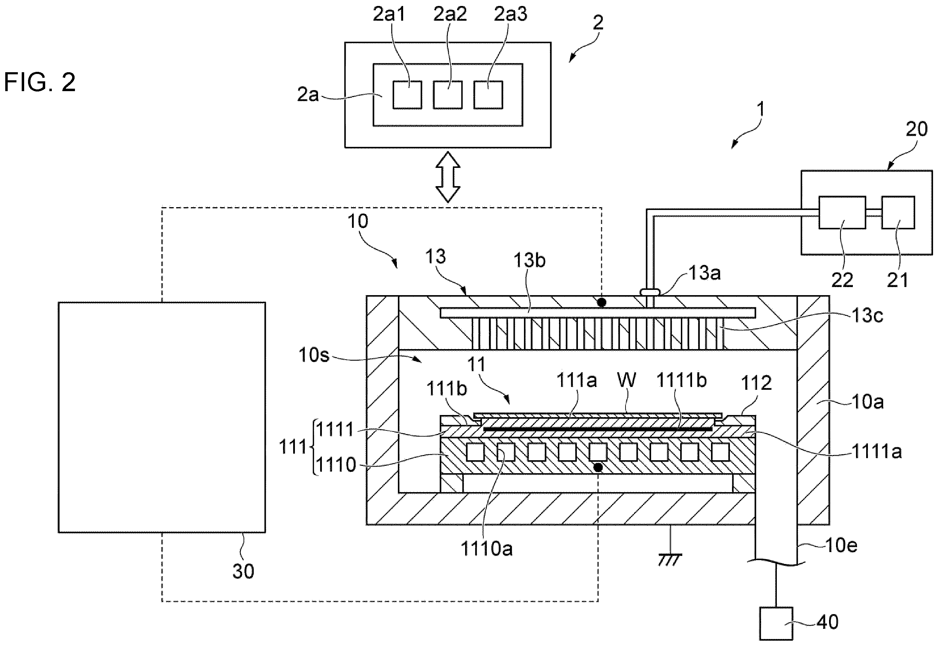

An example structure of a capacitively coupled plasma processing apparatus as an example of the plasma processing apparatus 1 will now be described. FIG. 2 is a diagram of the capacitively coupled plasma processing apparatus, describing an example structure.

The capacitively coupled plasma processing apparatus 1 includes the plasma processing chamber 10, the gas supply 20, a power supply system 30, and the exhaust system 40. The plasma processing apparatus 1 also includes the substrate support 11 and a gas guide unit. The gas guide unit allows at least one process gas to be introduced into the plasma processing chamber 10. The gas guide unit includes a shower head 13. The substrate support 11 is located in the plasma processing chamber 10. The shower head 13 is located above the substrate support 11. In one embodiment, the shower head 13 defines at least a part of the ceiling of the plasma processing chamber 10. The plasma processing chamber 10 has a plasma processing space 10s defined by the shower head 13, a side wall 10a of the plasma processing chamber 10, and the substrate support 11. The plasma processing chamber 10 is grounded. The substrate support 11 is electrically insulated from the housing of the plasma processing chamber 10.

The substrate support 11 includes a body 111 and a ring assembly 112. The body 111 includes a central area 111a for supporting a substrate W and an annular area 111b for supporting the ring assembly 112. A wafer is an example of the substrate W. The annular area 111b of the body 111 surrounds the central area 111a of the body 111 in a plan view. The substrate W is placed on the central area 111a of the body 111. The ring assembly 112 is placed on the annular area 111b of the body 111 to surround the substrate W on the central area 111a of the body 111. Thus, the central area 111a is also referred to as the substrate support surface for supporting the substrate W. The annular area 111b is also referred to as a ring support surface for supporting the ring assembly 112.

In one embodiment, the body 111 includes a base 1110 and an electrostatic chuck (ESC) 1111. The base 1110 includes a conductive member. The ESC 1111 is located on the base 1110. The ESC 1111 includes a ceramic member 1111a and an electrostatic electrode 1111b inside the ceramic member 1111a. The ceramic member 1111a includes the central area 111a. In one embodiment, the ceramic member 1111a also includes the annular area 111b. The annular area 111b may be included in another member surrounding the ESC 1111, such as an annular ESC or an annular insulating member. In this case, the ring assembly 112 may be located on either the annular ESC or the annular insulating member, or may be located on both the ESC 1111 and the annular insulating member.

The ring assembly 112 includes one or more annular members. In one embodiment, one or more annular members include one or more edge rings and at least one cover ring. The edge rings are formed from a conductive material or an insulating material. The cover ring is formed from an insulating material.

The substrate support 11 may also include a temperature control module that adjusts the temperature of at least one of the ESC 1111, the ring assembly 112, or the substrate to a target temperature. The temperature control module may include a heater, a heat transfer medium, a channel 1110a, or a combination of these. The channel 1110a allows a heat transfer fluid such as brine or gas to flow. In one embodiment, the channel 1110a is defined in the base 1110, and one or more heaters are located in the ceramic member 1111a in the ESC 1111. The substrate support 11 may include a heat transfer gas supply to supply a heat transfer gas into a space between the back surface of the substrate W and the central area 111a.

The shower head 13 introduces at least one process gas from the gas supply 20 into the plasma processing space 10s. The shower head 13 has at least one gas inlet 13a, at least one gas-diffusion compartment 13b, and multiple gas guides 13c. The process gas supplied to the gas inlet 13a passes through the gas-diffusion compartment 13b and is introduced into the plasma processing space 10s through the multiple gas guides 13c. The shower head 13 also includes at least one upper electrode. In addition to the shower head 13, the gas guide unit may include one or more side gas injectors (SGIs) installed in one or more openings in the side wall 10a.

The gas supply 20 may include at least one gas source 21 and at least one flow controller 22. In one embodiment, the gas supply 20 supplies at least one process gas from the corresponding gas source 21 to the shower head 13 through the corresponding flow controller 22. Each flow controller 22 may include, for example, a mass flow controller or a pressure-based flow controller. The gas supply 20 may further include at least one flow rate modulator that allows supply of at least one process gas at a modulated flow rate or in a pulsed manner.

The exhaust system 40 is connectable to, for example, a gas outlet 10e in the bottom of the plasma processing chamber 10. The exhaust system 40 may include a pressure control valve and a vacuum pump. The pressure control valve regulates the pressure in the plasma processing space 10s. The vacuum pump may include a turbomolecular pump, a dry pump, or a combination of these.

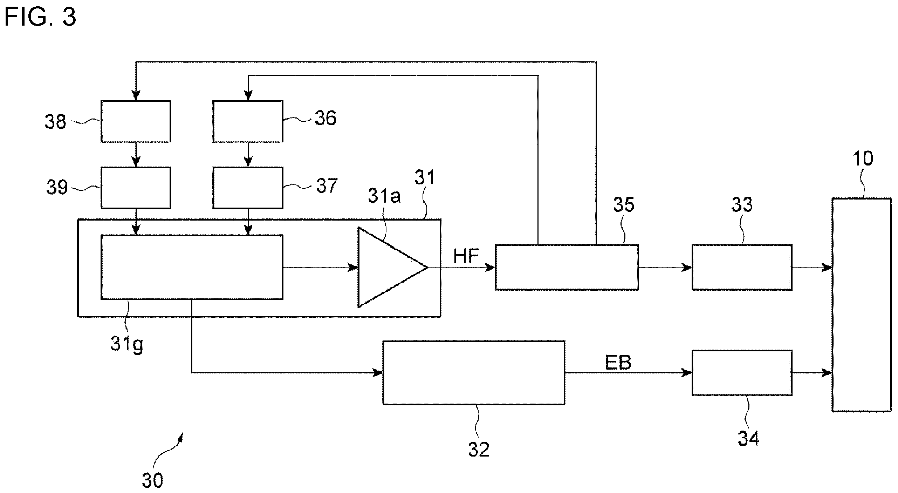

FIG. 3 will now be referred to in addition to FIG. 2. FIG. 3 is a diagram of the power supply system in the plasma processing apparatus according to one exemplary embodiment, showing an example structure. The power supply system 30 includes a radio-frequency (RF) power supply 31 and a bias power supply 32. The RF power supply 31 serves as the plasma generator 12 in one embodiment. The RF power supply 31 generates source RF power HF. The source RF power HF has a source frequency f_{S}. More specifically, the source RF power HF has a sinusoidal waveform with its frequency being the source frequency f_{S}. The source frequency f_{S} may be 10 to 150 MHz inclusive.

The RF power supply 31 is electrically coupled to an RF electrode through a matcher 33 to provide the source RF power HF to the RF electrode. The RF electrode may be located in the substrate support 11. The RF electrode may be the conductive member in the base 1110 or may be at least one electrode in the ceramic member 1111a. In some embodiments, the RF electrode may be an upper electrode. In response to the source RF power HF being provided to the RF electrode, plasma is generated from the gas in the chamber 10.

The matcher 33 has a variable impedance. The variable impedance of the matcher 33 is set to reduce reflection of the source RF power HF from a load. The matcher 33 may be controlled by, for example, the controller 2.

In one embodiment, the RF power supply 31 may include a signal generator 31g and an amplifier 31a. The signal generator 31g generates an RF signal having the source frequency f_{S}. The signal generator 31g may include a programmable processor or a programmable logic device such as a field-programmable gate array (FPGA).

The signal generator 31g has its output connected to the input of the amplifier 31a. The amplifier 31a amplifies the RF signal from the signal generator 31g to generate the source RF power HF. The amplifier 31a has the amplification rate specified by the controller 2 for the RF power supply 31.

The bias power supply 32 is electrically coupled to the substrate support 11. The bias power supply 32 is electrically coupled to a bias electrode in the substrate support 11 to provide an electrical bias EB to the bias electrode. The bias electrode may be the conductive member in the base 1110 or may be at least one electrode in the ceramic member 1111a. The bias electrode may be the same as the RF electrode. In response to the electrical bias EB being provided to the bias electrode, ions in the plasma are attracted toward the substrate W.

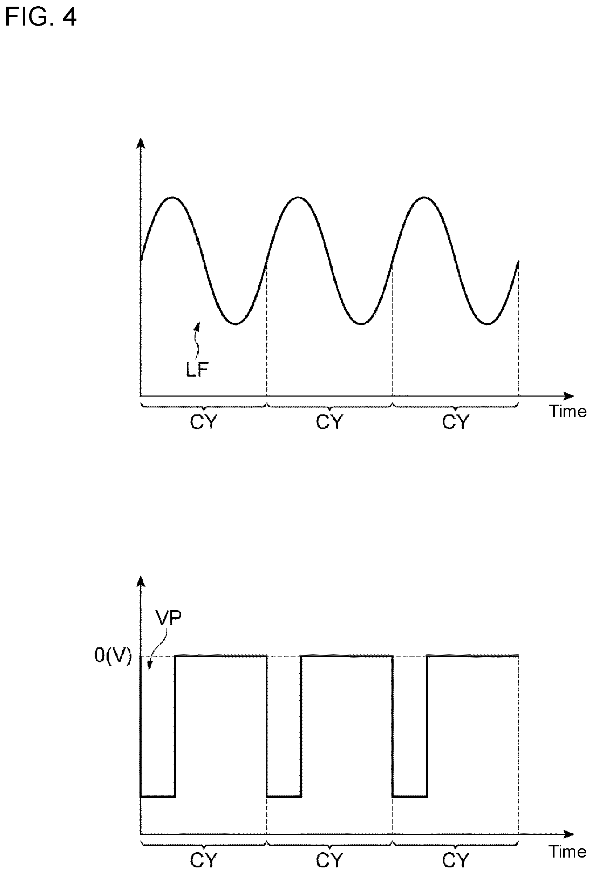

FIGs. 4A and 4B will now be referred to in addition to FIGs. 2 and 3. FIGs. 4A and 4B are graphs each showing an example waveform of an electrical bias. The bias power supply 32 cyclically provides the electrical bias EB having a waveform cycle CY to the bias electrode. More specifically, the electrical bias EB is repeatedly provided to the bias electrode in each of multiple waveform cycles CY. The waveform cycle CY is defined by a bias frequency. The bias frequency is, for example, 50 kHz to 27 MHz inclusive. The waveform cycle CY has a duration that is the inverse of the bias frequency.

As shown in FIG. 4A, the electrical bias EB may be bias RF power LF having the bias frequency. In other words, the electrical bias EB may have a sinusoidal waveform with its frequency being the bias frequency. In this case, the bias power supply 32 is electrically coupled to the bias electrode through a matcher 34. The matcher 34 has a variable impedance that is set to reduce reflection of the bias RF power LF from the load.

In some embodiments, as shown in FIG. 4B, the electrical bias EB may include a voltage pulse VP. The voltage pulse VP is applied to the bias electrode in the waveform cycle CY. The voltage pulse VP is cyclically applied to the bias electrode at a time interval equal to the duration of the waveform cycle CY. The voltage pulse VP may have a waveform that is rectangular, triangular, or in any other shape. The voltage pulse VP has a polarity that causes a potential difference between the substrate W and the plasma to draw ions from the plasma into the substrate W. The voltage pulse VP may be a pulse of a negative voltage or a pulse of a negative direct current (DC) voltage. When the electrical bias EB is the voltage pulse VP, the plasma processing apparatus 1 may not include the matcher 34. In this case, the bias power supply 32 may include a power supply (e.g., a DC power supply) and a waveform generator that generates the voltage pulse VP by generating the waveforms based on the voltage from the power supply.

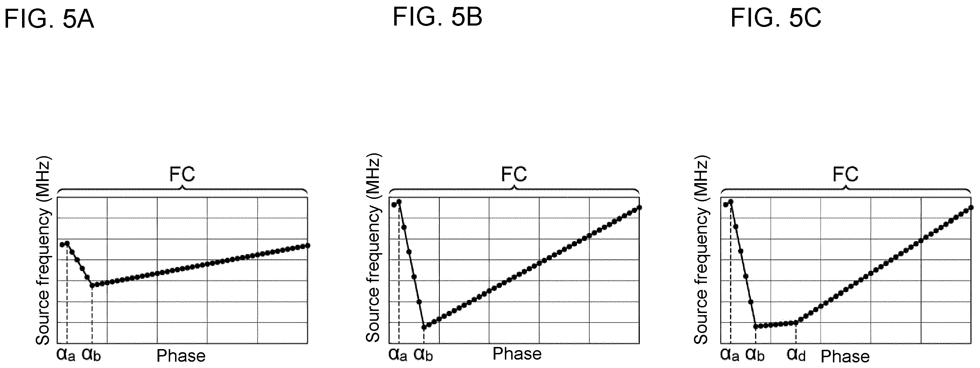

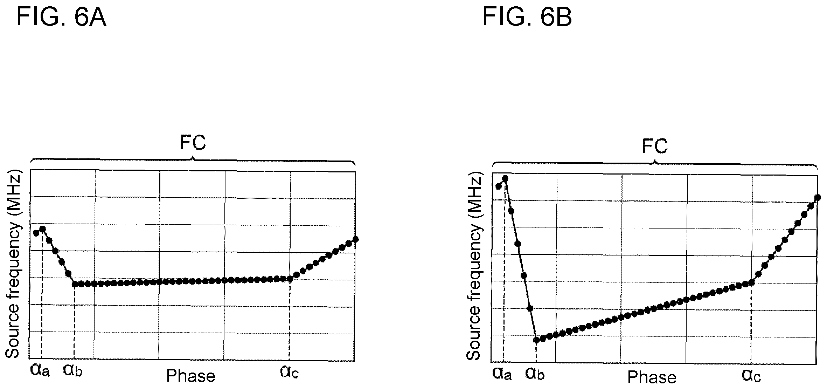

FIGs. 5A to 5C and FIGs. 6A and 6B are referred to in addition to FIGs. 2 and 3. FIGs. 5A to 6B are graphs each showing an example time series of source frequencies in the plasma processing apparatus according to the exemplary embodiment. The RF power supply 31 adjusts the source frequency f_{S} in a frequency adjustment cycle (hereafter referred to as a cycle FC) to reduce the degree of reflection of the source RF power HF. The signal generator 31g may cause the RF power supply 31 to perform processing including adjustment of the source frequency f_{S} described below. Another controller (e.g., the controller 2) may cause the RF power supply 31 to perform the adjustment.

The cycle FC has the same duration as the waveform cycle CY and is repeated in the same manner as the waveform cycle CY. The cycle FC includes multiple phases. The phases may be discretely set in the cycle FC. The phases in the cycle FC include at least two specific phases. At least two specific phases include a specific phase αₐ (a first specific phase) and a specific phase α_{b} (a second specific phase). The specific phase α_{b} follows the specific phase αₐ in the cycle FC. The phase difference between the specific phase αₐ and the specific phase α_{b} is predetermined.

The RF power supply 31 sets the time series of source frequencies f_{S} in the cycle FC to include a frequency in the specific phase αₐ, a frequency in the specific phase α_{b}, and an interpolated frequency in a phase other than the at least two specific phases. The frequency in the specific phase αₐ is the maximum frequency in the time series of source frequencies f_{S} in the cycle FC. The frequency in the specific phase α_{b} is the minimum frequency in the time series of source frequencies f_{S} in the cycle FC. The RF power supply 31 uses the frequencies linearly interpolated from the source frequencies in the at least two specific phases as source frequencies f_{S} in phases other than the at least two specific phases in the cycle FC. When the cycle FC is repeated, the RF power supply 31 interpolates the source frequency f_{S} in each of the phases between the first phase and the first specific phase and between the last specific phase and the last phase to maintain continuity or linearity of the source frequencies f_{S} between the last specific phase in a cycle FC and the first specific phase in the subsequent cycle FC.

The plasma processing apparatus 1 may further include a sensor 35 to identify the degree of reflection of the source RF power HF (refer to FIG. 3). The plasma processing apparatus 1 may further include an envelope detector 36 and an analog-to-digital (AD) converter 37. The plasma processing apparatus 1 may further include an envelope detector 38 and an AD converter 39.

The sensor 35 may include a directional coupler. The directional coupler causes the reflected wave of the source RF power HF from the load to branch. The directional coupler inputs the branched reflected wave into the envelope detector 36. The envelope detector 36 detects the envelope of the input reflected wave. The AD converter 37 performs AD conversion on the envelope detected by the envelope detector 36. The AD converter 37 may have a sampling frequency lower than the source frequency f_{S}. The AD converter 37 may have, for example, a sampling frequency lower than or equal to 20 MHz.

The directional coupler may cause the traveling wave of the source RF power HF to branch. The directional coupler may input the branched traveling wave into the envelope detector 38. The envelope detector 38 detects the envelope of the input traveling wave. The AD converter 39 performs AD conversion on the envelope detected by the envelope detector 38. The AD converter 39 may have a sampling frequency lower than the source frequency f_{S}. The AD converter 39 may have, for example, a sampling frequency lower than or equal to 20 MHz.

The RF power supply 31 averages the numerical values in the cycle FC sampled by the AD converter 37 to identify an average Prave of the power levels of the reflected wave of the source RF power HF in the cycle FC. The RF power supply 31 may use the average Prave as the degree of reflection in the cycle FC. In some embodiments, the RF power supply 31 may use the average of reflection coefficients in the cycle FC as the degree of reflection in the cycle FC. The reflection coefficient is a ratio of the value sampled by the AD converter 37 to the value sampled by the AD converter 39. The RF power supply 31 may use the degree of reflection of the source RF power HF calculated with measurement values obtained by another sensor.

The RF power supply 31 and the bias power supply 32 set a phase difference θ between the cycle FC and the waveform cycle CY to reduce the degree of reflection of the source RF power HF. In the cycle FC, the source frequency is changed based on a set of initial frequencies. As shown in FIG. 5A or FIG. 6A, the set of initial frequencies is a dataset that specifies the initial source frequencies in at least two specific phases such as the specific phase αₐ and the specific phase α_{b}. In one embodiment, the bias power supply 32 may adjust the timing of providing the electrical bias EB based on the timing control signal from the RF power supply 31 to adjust the phase difference θ between the cycle FC and the waveform cycle CY. In some embodiments, the RF power supply 31 may adjust the timing of starting the cycle FC to adjust the phase difference θ between the cycle FC and the waveform cycle CY.

In one embodiment, the RF power supply 31 may identify a phase difference θ_{A} for reducing reflection of the source RF power HF by the greatest degree, while changing the phase difference θ between the cycle FC and the waveform cycle CY. The RF power supply 31 may set the specific phase difference θ_{A} as the phase difference θ between the cycle FC and the waveform cycle CY. In one example, the RF power supply 31 sets the phase difference θ between the cycle FC and the waveform cycle CY to the initial phase difference. The RF power supply 31 then changes the phase difference θ. More specifically, the RF power supply 31 sets, as the phase difference θ, the value obtained by adding a change Δθ to the phase difference θ used previously. The RF power supply 31 initially sets the change Δθ as a predetermined initial change. When the degree of reflection of the source RF power HF decreases after changing the phase difference θ, the RF power supply 31 sets, as the phase difference θ to be used subsequently, the value obtained by adding the change Δθ to the current phase difference θ. When the degree of reflection of the source RF power HF increases after changing the phase difference θ, the RF power supply 31 updates the change Δθ to a product of the current change Δθ and (-1/2), and sets, as the phase difference θ to be used subsequently, the value obtained by adding the updated change Δθ to the current phase difference θ. The RF power supply 31 identifies, when the change Δθ has an absolute value smaller than a predetermined value, the phase difference θ as the phase difference θ_{A} for reducing reflection of the source RF power HF by the greatest degree. When the change Δθ has an absolute value greater than or equal to the predetermined value, the RF power supply 31 further changes the phase difference θ as described above.

In another embodiment, the RF power supply 31 may set the phase difference between the cycle FC and the waveform cycle CY to a predetermined phase difference, causing the specific phase αₐ to match a first timing and the specific phase α_{b} to match a second timing after the first timing. The first timing is the timing at which the voltage based on the electrical bias EB at the substrate support 11 switches from negative to positive. The second timing, which follows the first timing, is the timing at which the voltage based on the electrical bias EB at the substrate support 11 changes from negative to positive.

After setting the phase difference between the cycle FC and the waveform cycle CY, the RF power supply 31 adjusts the source frequency f_{S} in each phase in the cycle FC to reduce reflection of the source RF power HF. More specifically, the RF power supply 31 changes the maximum frequency in the specific phase αₐ and the minimum frequency in the specific phase α_{b} in the time series of source frequencies f_{S} in the cycle FC in the direction opposite to each other. In other words, the RF power supply 31 expands, reduces, or expands and reduces the bandwidth between the maximum frequency and the minimum frequency in the time series of source frequencies f_{S} in the cycle FC. The RF power supply 31 identifies the source frequency in each of the specific phase αₐ and the specific phase α_{b} for lowering or reducing reflection of the source RF power HF by the greatest degree while expanding, reducing, or expanding and reducing the bandwidth in a sequence of cycles FC.

The source frequency f_{S} in each phase in the cycle FC is adjusted by expanding, reducing, or expanding and reducing the bandwidth as described above with sequential processing or interpulse processing. When the sequence of the cycles FC includes consecutive multiple cycles FC, the source frequency f_{S} is adjusted with the sequential processing. When a pulse of the source RF power HF is cyclically provided, the source frequency f_{S} is adjusted with the interpulse processing (described later). The sequential processing and the interpulse processing in the first to third embodiments will now be described.

In the first embodiment, at least two specific phases in the cycle FC may be the specific phase αₐ and the specific phase α_{b} alone. In this case, in each of the sequential processing and the interpulse processing, the RF power supply 31 may set the source frequencies f_{S} in phases other than the specific phase αₐ and the specific phase α_{b} in the cycle FC to the frequencies linearly interpolated from the maximum frequency in the specific phase αₐ and the minimum frequency in the specific phase αₐ, as shown in FIG. 5B.

In the second embodiment, at least two specific phases in the cycle FC may be at least three specific phases. For example, at least three specific phases may include a specific phase α_{c} in addition to the specific phase αₐ and the specific phase α_{b}, as shown in FIG. 6A. The specific phase α_{c} may follow the specific phase α_{b} in the cycle FC or may be between the specific phase αₐ and the specific phase α_{b}.

In the second embodiment, in each of the sequential processing and the interpulse processing, the RF power supply 31 uses an initial frequency as the source frequency in a specific phase other than the specific phase αₐ and the specific phase α_{b} in the cycle FC. The initial frequency is a predetermined initial value of the source frequency in the specific phase other than the specific phase αₐ and the specific phase α_{b} in the cycle FC. In the second embodiment, in each of the sequential processing and the interpulse processing, the RF power supply 31 uses the frequencies linearly interpolated from the source frequencies in the at least three specific phases as the source frequencies f_{S} in phases other than the at least three specific phases in the cycle FC.

In the second embodiment, in each of the sequential processing and the interpulse processing, the RF power supply 31 expands, reduces, or expands and reduces the bandwidth as described above, with the initial frequency in a specific phase other than the specific phase αₐ and the specific phase α_{b} being fixed, to fix the source frequencies f_{S} in the specific phase αₐ and the specific phase α_{b}. In each of the sequential processing and the interpulse processing, the RF power supply 31 then changes the source frequency f_{S} in another specific phase other than the specific phase αₐ and the specific phase α_{b} in the cycle FC and identifies the source frequency f_{S} in the other specific phase for lowering or reducing reflection of the source RF power HF by the greatest degree, as shown in FIG. 6B. When the cycle FC includes multiple other specific phases other than the specific phase αₐ and the specific phase α_{b}, the source frequencies f_{S} in the multiple other specific phases may be changed sequentially or simultaneously to identify the source frequencies f_{S} in the multiple other specific phases for lowering or reducing reflection of the source RF power HF by the greatest degree.

In the third embodiment, in each of the sequential processing and the interpulse processing, the RF power supply 31 expands, reduces, or expands and reduces the bandwidth as described above while setting the frequencies in other phases other than the specific phase αₐ and the specific phase α_{b} in the cycle FC through linear interpolation of the source frequencies in the specific phase αₐ and the specific phase α_{b}. The RF power supply 31 then fixes the source frequency f_{S} in each of the specific phase αₐ and the specific phase α_{b} identified by expanding, reducing, or expanding and reducing the bandwidth as described above. The RF power supply 31 then changes the source frequency in at least one other specific phase (e.g., a specific phase α_{d} in FIG. 5C) other than the specific phase αₐ and the specific phase α_{b} in the cycle FC to identify the source frequency f_{S} in the at least one other specific phase for lowering or reducing reflection of the source RF power HF by the greatest degree. When the cycle FC includes multiple other specific phases other than the specific phase αₐ and the specific phase α_{b}, the source frequencies f_{S} in the multiple other specific phases may be changed sequentially or simultaneously to identify the source frequencies f_{S} in the multiple other specific phases for lowering or reducing reflection of the source RF power HF by the greatest degree. In the third embodiment, in each of the sequential processing and the interpulse processing, after fixing the source frequency f_{S} in each of the specific phase αₐ and the specific phase α_{b}, the RF power supply 31 uses the frequencies linearly interpolated from the source frequencies in the specific phase αₐ, the specific phase α_{b}, and the at least one other specific phase as the source frequencies f_{S} in phases other than the specific phase αₐ, the specific phase α_{b}, and the at least one other phase in the cycle FC.

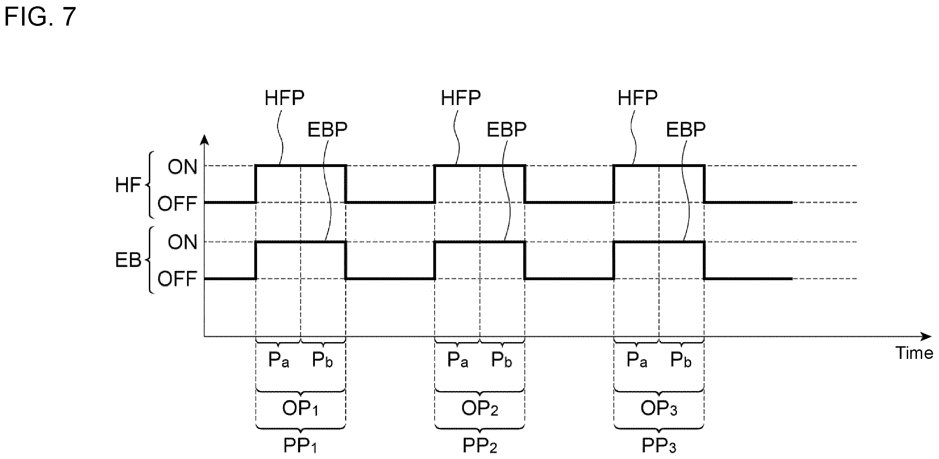

FIG. 7 will now be referred to. FIG. 7 is a graph showing an example pulse of source RF power and an example pulse of an electrical bias. In FIG. 7, the source RF power HF being ON indicates the source RF power HF being provided, and the source RF power HF being OFF indicates the source RF power HF being stopped. In the figure, the electrical bias EB being ON indicates the electrical bias EB being provided to the bias electrode, and the electrical bias EB being OFF indicates the electrical bias EB not being provided to the bias electrode.

As shown in FIG. 7, the RF power supply 31 may cyclically provide a pulse HFP of the source RF power HF. The bias power supply 32 may cyclically provide a pulse EBP of the electrical bias EB. The pulse HFP and the pulse EBP may be provided for each of multiple pulse periods, or in other words, pulse periods PP₁, PP₂, ..., PP_{K}. More specifically, the pulse HFP and the pulse EBP are provided at the same time in each of multiple overlap periods OP (in other words, overlap periods OP₁, OP₂, ..., OP_{K}) that are the same as the respective pulse periods PP. In some embodiments, the periods in which the pulse HFP is provided and the periods in which the pulse EBP is provided may be shifted from each other while partially overlapping each other. In this case, each of the multiple overlap periods OP is a part of the period in which the pulse HFP is provided and also a part of the period in which the pulse EBP is provided.

Each of the overlap periods OP includes a first period Pₐ and a second period P_{b}. Each first period Pₐ includes a start point of the corresponding overlap period OP. Each second period P_{b} follows the corresponding first period Pₐ and includes an end point of the corresponding overlap period OP. The first period Pₐ and the second period P_{b} each include a repeat of cycles FC and a repeat of waveform cycles CY. More specifically, each of the multiple overlap periods OP includes N cycles FC, or in other words, a cycle FC₁ to a cycle FC_{N}. A cycle FCₙ hereafter refers to the n-th cycle FC of the multiple cycles FC in each of the multiple overlap periods OP.

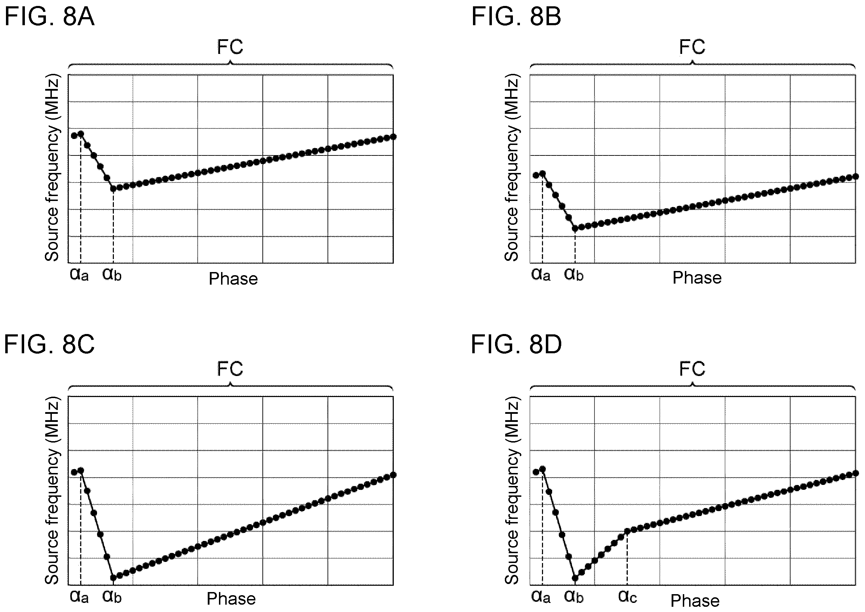

FIGs. 8A to 8D will now be referred to. FIGs. 8A to 8D are graphs each showing an example time series of source frequencies in the plasma processing apparatus according to the exemplary embodiment.

When the pulse HFP and the pulse EBP are provided cyclically, the RF power supply 31 first sets the phase difference between the cycle FC and the waveform cycle CY as described above. In setting the phase difference between the cycle FC and the waveform cycle CY, the time series of source frequencies f_{S} in the cycle FC is set based on a set of initial frequencies, as described above. A set of initial frequencies applied to the cycle FCₙ in the first period Pₐ may be different from or the same as a set of initial frequencies applied to the cycle FC in the second period P_{b}. The RF power supply 31 may determine the phase difference between the cycle FC and the waveform cycle CY based only on the degree of reflection in each cycle FC in the second period P_{b}.

After setting the phase difference between the cycle FC and the waveform cycle CY, the RF power supply 31 adjusts the source frequency f_{S} in the cycle FC to reduce the degree of reflection of the source RF power HF in the cycle FC. When the pulse HFP and the pulse EBP are provided cyclically, a cycle FCₙ in the first period Pₐ of each of the multiple overlap periods OP includes a sequence of the cycle FCₙ.

The RF power supply 31 may use, as the time series of source frequencies f_{S} in the cycle FCₙ in the first period Pₐ, a time series of frequencies offset to lower frequencies from the time series of source frequencies f_{S} specified by the set of initial frequencies used in the second period P_{b}. The time series of source frequencies f_{S} in the cycle FCₙ in the first period Pₐ may be offset by a predetermined frequency from the time series of source frequencies f_{S} in the cycle FCₙ in the second period P_{b}. In some embodiments, as shown in FIGs. 8A and 8B, the RF power supply 31 may identify the offset level for reducing reflection of the source RF power HF by the greatest degree by offsetting the time series of source frequencies f_{S} to lower frequencies with different offset levels in the sequence of cycle FCₙ in the first period Pₐ in each of the multiple overlap periods OP.

The RF power supply 31 then applies the sequential processing described above to the multiple consecutive cycles FC in the second period P_{b} in each of the multiple overlap periods OP. The RF power supply 31 also applies the interpulse processing described above to the multiple consecutive cycles FC in the first period Pₐ in each of the multiple overlap periods OP. The interpulse processing is applied to the sequence of cycle FCₙ. The time series of source frequencies f_{S} in the cycles FC in the first period Pₐ is adjusted through the interpulse processing, as shown in FIG. 8C, FIG. 8D, or both of these figures.

As described above, the plasma processing apparatus 1 uses the time series of source frequencies f_{S} of the source RF power HF that reduces the degree of reflection of the source RF power HF in the cycle FC having the same duration as the waveform cycle CY. Thus, the degree of reflection of the source RF power HF is reduced based on the change in the impedance of the load on the RF power supply 31 in the cycles of the electrical bias EB. The plasma processing apparatus 1 sets the time series of source frequencies f_{S} by adjusting the phase difference between the cycle FC and the waveform cycle CY and by adjusting the bandwidth between the source frequency f_{S} in the specific phase αₐ and the source frequency f_{S} in the specific phase α_{b}. The plasma processing apparatus 1 thus performs relatively simple processing to set the time series of source frequencies f_{S} of the source RF power HF for reducing the degree of reflection of the source RF power HF in the cycle FC. In one embodiment, the degree of reflection of the source RF power HF can be identified with the AD conversion using relatively low-speed sampling.

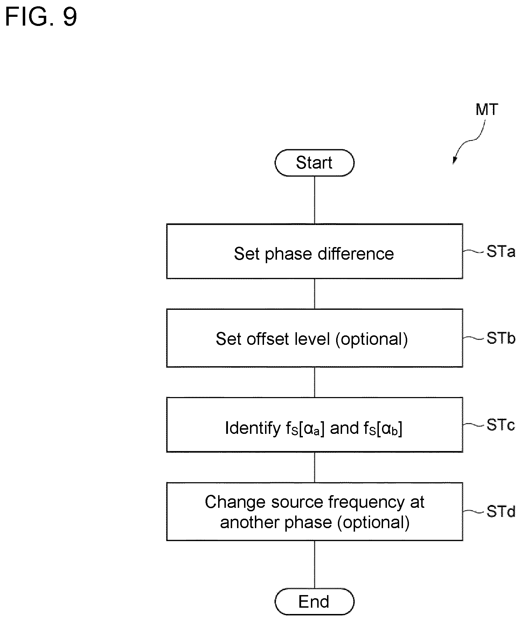

A method for controlling the source frequency according to one exemplary embodiment will now be described with reference to FIG. 9. FIG. 9 is a flowchart of the method for controlling the source frequency according to the exemplary embodiment. The method for controlling the source frequency shown in FIG. 9 (hereafter referred to as a method MT) starts in step STa.

In step STa, the phase difference between the cycle FC and the waveform cycle CY is set as described above.

In one embodiment, the method MT may include step STb. Step STb may be performed when the pulse HFP and the pulse EBP are provided cyclically. In step STb, the offset level of the frequency with respect to the time series of source frequencies f_{S} in a cycle FCₙ in the first period Pₐ is set as described above.

Step STc in the method MT is then performed. In step STc, the source frequency f_{S}[αₐ] and the source frequency f_{S}[α_{b}] that reduce the degree of reflection of the source RF power HF are identified based on the adjustment of the source frequency f_{S}[αₐ] in the specific phase αₐ and the source frequency f_{S}[α_{b}] in the specific phase α_{b}. Step STc is performed in the manner described in detail above for the sequential processing and the interpulse processing.

The method MT may further include step STd. Step STd follows step STc. In step STd, as described in the second embodiment, the source frequency f_{S} in another specific phase other than the specific phase αₐ and the specific phase α_{b} is changed to identify the source frequency f_{S} in the other specific phase that reduces the degree of reflection of the source RF power HF. In some embodiments, in step STd, as described in the third embodiment, the source frequency f_{S} in at least one specific phase other than the specific phase αₐ and the specific phase α_{b} in the cycle FC is changed to identify the source frequency f_{S} in the at least one specific phase that reduces the degree of reflection of the source RF power HF.

Various exemplary embodiments E1 to E13 included in the disclosure will now be described.

### E1

A plasma processing apparatus, comprising:
a chamber;
a substrate support in the chamber;
a radio-frequency power supply configured to generate source radio-frequency power having a source frequency to generate plasma from a gas in the chamber; and
a bias power supply configured to provide an electrical bias having a waveform cycle to the substrate support to draw ions from plasma in the chamber,
wherein the radio-frequency power supply sets a time series of source frequencies of the source radio-frequency power in a frequency adjustment cycle having a same duration as the waveform cycle to include a maximum frequency in a first specific phase, a minimum frequency in a second specific phase, and an interpolated frequency in a phase other than at least two specific phases including the first specific phase and the second specific phase,
the radio-frequency power supply and the bias power supply set a phase difference between the frequency adjustment cycle and the waveform cycle to reduce a degree of reflection of the source radio-frequency power, and the frequency adjustment cycle has the source frequency changed based on a set of initial frequencies specifying initial source frequencies in the at least two specific phases, and
the radio-frequency power supply identifies, after setting the phase difference, the source frequency in the first specific phase and the source frequency in the second specific phase to reduce the degree of reflection of the source radio-frequency power while changing the maximum frequency in the first specific phase and the minimum frequency in the second specific phase in the time series of the source frequencies in the frequency adjustment cycle in a direction opposite to each other.

### E2

The plasma processing apparatus according to E1, wherein
the radio-frequency power supply identifies the phase difference to reduce reflection of the source radio-frequency power by a greatest degree while changing the phase difference, and sets the specific phase difference as a phase difference between the frequency adjustment cycle and the waveform cycle.

### E3

The plasma processing apparatus according to E1, wherein
the phase difference is set to cause the first specific phase to match a first timing at which a voltage based on the electrical bias at the substrate support switches from negative to positive and cause the second specific phase to match a second timing at which a voltage based on the electrical bias at the substrate support changes from negative to positive, and the second timing follows the first timing.

### E4

The plasma processing apparatus according to any one of E1 to E3, wherein
the radio-frequency power supply sets the source frequency in a phase other than the first specific phase and the second specific phase in the frequency adjustment cycle to a frequency linearly interpolated from the maximum frequency in the first specific phase and the minimum frequency in the second specific phase.

### E5

The plasma processing apparatus according to any one of E1 to E3, wherein
the at least two specific phases include at least three specific phases,
the radio-frequency power supply uses an initial frequency as the source frequency in a specific phase other than the first specific phase and the second specific phase of the at least three specific phases, and uses a frequency linearly interpolated from source frequencies in the at least three specific phases as a source frequency in a phase other than the at least three specific phases in the frequency adjustment cycle, and
the radio-frequency power supply changes, after fixing the source frequency in the first specific phase and the source frequency in the second specific phase to frequencies identified by changing the maximum frequency in the first specific phase and the minimum frequency in the second specific phase in a direction opposite to each other, the source frequency in a specific phase other than the first specific phase and the second specific phase of the at least three specific phases to reduce the degree of reflection of the source radio-frequency power.

### E6

The plasma processing apparatus according to any one of E1 to E3, wherein
the radio-frequency power supply sets the source frequencies in a phase other than the first specific phase and the second specific phase in the frequency adjustment cycle to a frequency linearly interpolated from the maximum frequency in the first specific phase and the minimum frequency in the second specific phase, and
the radio-frequency power supply changes, after fixing the source frequency in the first specific phase and the source frequency in the second specific phase to frequencies identified by changing the maximum frequency in the first specific phase and the minimum frequency in the second specific phase in a direction opposite to each other, the source frequency in a phase other than the first specific phase and the second specific phase in the frequency adjustment cycle to reduce the degree of reflection of the source radio-frequency power.

### E7

The plasma processing apparatus according to any one of E1 to E6, further comprising:
a directional coupler coupled between the radio-frequency power supply and a load on the radio-frequency power supply;
an envelope detection circuit configured to detect an envelope of a reflected wave of the source radio-frequency power, the reflected wave being output from the directional coupler; and
an analog-to-digital conversion circuit configured to perform analog-to-digital conversion of the envelope,
wherein the radio-frequency power supply identifies the degree of reflection based on an average of amplitudes of the envelope in the frequency adjustment cycle digitized by the analog-to-digital conversion circuit.

### E8

The plasma processing apparatus according to E7, wherein
the analog-to-digital conversion circuit has a sampling frequency lower than the source frequency of the source radio-frequency power.

### E9

The plasma processing apparatus according to any one of E1 to E8, wherein
the radio-frequency power supply cyclically provides a pulse of the source radio-frequency power,
the bias power supply cyclically provides a pulse of the electrical bias,
the pulse of the source radio-frequency power and the pulse of the electrical bias are provided at the same time in a first period and a second period following the first period, and
the radio-frequency power supply uses, as the time series of the source frequencies in the frequency adjustment cycle in the first period, a time series of frequencies offset to lower frequencies from the time series of the source frequencies specified by the set of initial frequencies used in the second period.

### E10

The plasma processing apparatus according to E9, wherein
the radio-frequency power supply identifies, based only on the degree of reflection in the second period, the phase difference to reduce reflection of the source radio-frequency power by a greatest degree while changing the phase difference.

### E11

The plasma processing apparatus according to any one of E1 to E10, wherein
the electrical bias is bias radio-frequency power having a bias frequency being an inverse of the duration of the waveform cycle, or the electrical bias includes a voltage pulse cyclically provided at an interval equal to the duration of the waveform cycle.

### E12

A power supply system, comprising:
a radio-frequency power supply configured to generate source radio-frequency power having a source frequency to generate plasma from a gas in a chamber in a plasma processing apparatus; and
a bias power supply configured to provide an electrical bias having a waveform cycle to a substrate support in the chamber to draw ions from plasma in the chamber,
wherein the radio-frequency power supply sets a time series of source frequencies of the source radio-frequency power in a frequency adjustment cycle having a same duration as the waveform cycle to include a maximum frequency in a first specific phase, a minimum frequency in a second specific phase, and an interpolated frequency in a phase other than at least two specific phases including the first specific phase and the second specific phase,
the radio-frequency power supply and the bias power supply set a phase difference between the frequency adjustment cycle and the waveform cycle to reduce a degree of reflection of the source radio-frequency power, and the frequency adjustment cycle has the source frequency changed based on a set of initial frequencies specifying initial source frequencies in the at least two specific phases, and
the radio-frequency power supply identifies, after setting the phase difference, the source frequency in the first specific phase and the source frequency in the second specific phase to reduce the degree of reflection of the source radio-frequency power while changing the maximum frequency in the first specific phase and the minimum frequency in the second specific phase in the time series of source frequencies in the frequency adjustment cycle in a direction opposite to each other.

### E13

A method for controlling a source frequency, the method comprising:
(a) providing source radio-frequency power having a source frequency from a radio-frequency power supply to generate plasma from a gas in a chamber in a plasma processing apparatus;
(b) providing an electrical bias having a waveform cycle from a bias power supply to a substrate support in the chamber to draw ions from plasma in the chamber,
   (a) including setting, with the radio-frequency power supply, a time series of source frequencies of the source radio-frequency power in a frequency adjustment cycle having a same duration as the waveform cycle to include a maximum frequency in a first specific phase, a minimum frequency in a second specific phase, and an interpolated frequency in a phase other than at least two specific phases including the first specific phase and the second specific phase;
(c) setting a phase difference between the frequency adjustment cycle and the waveform cycle to reduce a degree of reflection of the source radio-frequency power, the frequency adjustment cycle having the source frequency changed based on a set of initial frequencies specifying initial source frequencies in the at least two specific phases; and
(d) identifying, after setting the phase difference, the source frequency in the first specific phase and the source frequency in the second specific phase to reduce the degree of reflection of the source radio-frequency power while changing the maximum frequency in the first specific phase and the minimum frequency in the second specific phase in the time series of the source frequencies in the frequency adjustment cycle in a direction opposite to each other.

The exemplary embodiments according to the disclosure have been described by way of example, and various changes may be made without departing from the scope and spirit of the disclosure. The exemplary embodiments described above are thus not restrictive, and the true scope and spirit of the disclosure are defined by the appended claims.

### REFERENCE SIGNS LIST

- 1: Plasma processing apparatus
- 10: Chamber
- 11: Substrate support
- 31: Radio-frequency (RF) power supply
- 32: Bias power supply

## Claims

1. A plasma processing apparatus, comprising:
a chamber;
a substrate support in the chamber;
a radio-frequency power supply configured to generate source radio-frequency power having a source frequency to generate plasma from a gas in the chamber; and
a bias power supply configured to provide an electrical bias having a waveform cycle to the substrate support to draw ions from plasma in the chamber,
wherein the radio-frequency power supply sets a time series of source frequencies of the source radio-frequency power in a frequency adjustment cycle having a same duration as the waveform cycle to include a maximum frequency in a first specific phase, a minimum frequency in a second specific phase, and an interpolated frequency in a phase other than at least two specific phases including the first specific phase and the second specific phase,
the radio-frequency power supply and the bias power supply set a phase difference between the frequency adjustment cycle and the waveform cycle to reduce a degree of reflection of the source radio-frequency power, and the frequency adjustment cycle has the source frequency changed based on a set of initial frequencies specifying initial source frequencies in the at least two specific phases, and
the radio-frequency power supply identifies, after setting the phase difference, the source frequency in the first specific phase and the source frequency in the second specific phase to reduce the degree of reflection of the source radio-frequency power while changing the maximum frequency in the first specific phase and the minimum frequency in the second specific phase in the time series of the source frequencies in the frequency adjustment cycle in a direction opposite to each other.

2. The plasma processing apparatus according to claim 1, wherein
the radio-frequency power supply identifies the phase difference to reduce reflection of the source radio-frequency power by a greatest degree while changing the phase difference, and sets the specific phase difference as a phase difference between the frequency adjustment cycle and the waveform cycle.

3. The plasma processing apparatus according to claim 1, wherein
the phase difference is set to cause the first specific phase to match a first timing at which a voltage based on the electrical bias at the substrate support switches from negative to positive and cause the second specific phase to match a second timing at which a voltage based on the electrical bias at the substrate support changes from negative to positive, and the second timing follows the first timing.

4. The plasma processing apparatus according to any one of claims 1 to 3, wherein
the radio-frequency power supply sets the source frequency in a phase other than the first specific phase and the second specific phase in the frequency adjustment cycle to a frequency linearly interpolated from the maximum frequency in the first specific phase and the minimum frequency in the second specific phase.

5. The plasma processing apparatus according to any one of claims 1 to 3, wherein
the at least two specific phases include at least three specific phases,
the radio-frequency power supply uses an initial frequency as the source frequency in a specific phase other than the first specific phase and the second specific phase of the at least three specific phases, and uses a frequency linearly interpolated from source frequencies in the at least three specific phases as a source frequency in a phase other than the at least three specific phases in the frequency adjustment cycle, and
the radio-frequency power supply changes, after fixing the source frequency in the first specific phase and the source frequency in the second specific phase to frequencies identified by changing the maximum frequency in the first specific phase and the minimum frequency in the second specific phase in a direction opposite to each other, the source frequency in a specific phase other than the first specific phase and the second specific phase of the at least three specific phases to reduce the degree of reflection of the source radio-frequency power.

6. The plasma processing apparatus according to any one of claims 1 to 3, wherein
the radio-frequency power supply sets the source frequencies in a phase other than the first specific phase and the second specific phase in the frequency adjustment cycle to a frequency linearly interpolated from the maximum frequency in the first specific phase and the minimum frequency in the second specific phase, and
the radio-frequency power supply changes, after fixing the source frequency in the first specific phase and the source frequency in the second specific phase to frequencies identified by changing the maximum frequency in the first specific phase and the minimum frequency in the second specific phase in a direction opposite to each other, the source frequency in a phase other than the first specific phase and the second specific phase in the frequency adjustment cycle to reduce the degree of reflection of the source radio-frequency power.

7. The plasma processing apparatus according to any one of claims 1 to 3, further comprising:
a directional coupler coupled between the radio-frequency power supply and a load on the radio-frequency power supply;
an envelope detection circuit configured to detect an envelope of a reflected wave of the source radio-frequency power, the reflected wave being output from the directional coupler; and
an analog-to-digital conversion circuit configured to perform analog-to-digital conversion of the envelope,
wherein the radio-frequency power supply identifies the degree of reflection based on an average of amplitudes of the envelope in the frequency adjustment cycle digitized by the analog-to-digital conversion circuit.

8. The plasma processing apparatus according to claim 7, wherein
the analog-to-digital conversion circuit has a sampling frequency lower than the source frequency of the source radio-frequency power.

9. The plasma processing apparatus according to any one of claims 1 to 3, wherein
the radio-frequency power supply cyclically provides a pulse of the source radio-frequency power,
the bias power supply cyclically provides a pulse of the electrical bias,
the pulse of the source radio-frequency power and the pulse of the electrical bias are provided at the same time in a first period and a second period following the first period, and
the radio-frequency power supply uses, as the time series of the source frequencies in the frequency adjustment cycle in the first period, a time series of frequencies offset to lower frequencies from the time series of the source frequencies specified by the set of initial frequencies used in the second period.

10. The plasma processing apparatus according to claim 9, wherein
the radio-frequency power supply identifies, based only on the degree of reflection in the second period, the phase difference to reduce reflection of the source radio-frequency power by a greatest degree while changing the phase difference.

11. The plasma processing apparatus according to any one of claims 1 to 3, wherein
the electrical bias is bias radio-frequency power having a bias frequency being an inverse of the duration of the waveform cycle, or the electrical bias includes a voltage pulse cyclically provided at an interval equal to the duration of the waveform cycle.

12. A power supply system, comprising:
a radio-frequency power supply configured to generate source radio-frequency power having a source frequency to generate plasma from a gas in a chamber in a plasma processing apparatus; and
a bias power supply configured to provide an electrical bias having a waveform cycle to a substrate support in the chamber to draw ions from plasma in the chamber,
wherein the radio-frequency power supply sets a time series of source frequencies of the source radio-frequency power in a frequency adjustment cycle having a same duration as the waveform cycle to include a maximum frequency in a first specific phase, a minimum frequency in a second specific phase, and an interpolated frequency in a phase other than at least two specific phases including the first specific phase and the second specific phase,
the radio-frequency power supply and the bias power supply set a phase difference between the frequency adjustment cycle and the waveform cycle to reduce a degree of reflection of the source radio-frequency power, and the frequency adjustment cycle has the source frequency changed based on a set of initial frequencies specifying initial source frequencies in the at least two specific phases, and
the radio-frequency power supply identifies, after setting the phase difference, the source frequency in the first specific phase and the source frequency in the second specific phase to reduce the degree of reflection of the source radio-frequency power while changing the maximum frequency in the first specific phase and the minimum frequency in the second specific phase in the time series of source frequencies in the frequency adjustment cycle in a direction opposite to each other.

13. A method for controlling a source frequency, the method comprising:
(a) providing source radio-frequency power having a source frequency from a radio-frequency power supply to generate plasma from a gas in a chamber in a plasma processing apparatus;
(b) providing an electrical bias having a waveform cycle from a bias power supply to a substrate support in the chamber to draw ions from plasma in the chamber,
(a) including setting, with the radio-frequency power supply, a time series of source frequencies of the source radio-frequency power in a frequency adjustment cycle having a same duration as the waveform cycle to include a maximum frequency in a first specific phase, a minimum frequency in a second specific phase, and an interpolated frequency in a phase other than at least two specific phases including the first specific phase and the second specific phase;
(c) setting a phase difference between the frequency adjustment cycle and the waveform cycle to reduce a degree of reflection of the source radio-frequency power, the frequency adjustment cycle having the source frequency changed based on a set of initial frequencies specifying initial source frequencies in the at least two specific phases; and
(d) identifying, after setting the phase difference, the source frequency in the first specific phase and the source frequency in the second specific phase to reduce the degree of reflection of the source radio-frequency power while changing the maximum frequency in the first specific phase and the minimum frequency in the second specific phase in the time series of the source frequencies in the frequency adjustment cycle in a direction opposite to each other.
